# EUROPEAN PATENT SPECIFICATION

(11) **EP 0 478 463 B1**
(45) Date of publication and mention of the grant of the patent: **08.05.1996**
(21) Application number: 91402593.7
(22) Date of filing: 27.09.1991
(51) Int. Cl.: H01L 39/22

(54) **Superconducting device having an extremely thin superconducting channel formed of oxide superconductor material**
Supraleitendes Bauelement mit extrem dünnem supraleitenden Kanal aus supraleitendem Oxidmaterial
Dispositif à supraconducteur avec un canal supraconducteur extrêmement mince formé d'un matériau d'oxyde supraconducteur

(30) Priority: 27.09.1990 JP 257854/90; 01.11.1990 JP 295657/90
(43) Date of publication of application: 01.04.1992
(73) Proprietor: Sumitomo Electric Industries, Ltd., Osaka 541 (JP)
(72) Inventor: Nakamura, Takao, F-75116 Paris (FR); Inada, Hiroshi, F-75116 Paris (FR); Iiyama, Michitomo, F-75116 Paris (FR)
(74) Representative: Ballot, Paul Denis Jacques

(56) References cited:
- EP-A- 0 276 746
- EP-A- 0 280 308
- EP-A- 0 354 804
- EP-A- 0 477 063
- PROCEEDINGS OF THE IEEE, vol. 77, no. 8, August 1989, pages 1155-1163, New York, US; M.R. BEASLEY: "High-Temperature Superconductive Thin Films"
- PATENT ABSTRACTS OF JAPAN, vol. 13, no. 195 (E- 754)(3543), 10 May 1989 & JP-A-115 988

## Description

### Background of the Invention

### Field of the invention

The present invention relates to a superconducting device, and more specifically to a superconducting device including an extremely thin superconducting channel formed of oxide superconductor material.

### Description of related art

Typical three-terminal devices which utilize a superconductor include a so called superconducting-base transistor and a so called super-FET (field effect transistor). The superconducting-base transistor includes an emitter of a superconductor or a normal conductor, a tunnel barrier of an insulator, a base of a superconductor, a semiconductor isolator and a collector of a normal conductor, stacked in the named order. This superconducting-base transistor operates at a high speed with a low power consumption, by utilizing high speed electrons passing through the tunnel barrier.

The super-FET includes a semiconductor layer, and a superconductor source electrode and a superconductor drain electrode which are formed closely to each other on the semiconductor layer. A portion of the semiconductor layer between the superconductor source electrode and the superconductor drain electrode has a greatly recessed or undercut rear surface so as to have a reduced thickness. In addition, a gate electrode is formed through a gate insulator layer on the recessed or undercut rear surface of the portion of the semiconductor layer between the superconductor source electrode and the superconductor drain electrode.

A superconducting current flows through the semiconductor layer portion between the superconductor source electrode and the superconductor drain electrode due to a superconducting proximity effect, and is controlled by an applied gate voltage. This super-FET also operates at a high speed with a low power consumption.

In addition, in the prior art, there has been proposed a three-terminal superconducting device having a channel of a superconductor formed between a source electrode and a drain electrode, so that a current flowing through the superconducting channel is controlled by a voltage applied to a gate formed above the superconducting channel.

Moreover patent Applications EP-A-0 354 804 and EP-A-0 477 063 disclose a superconducting device comprising a substrate, a thin film of an oxide superconductor constituting a superconducting channel, source, drain and gate electrodes, an insulating layer provides between the gate electrode and the superconducting channel, wherein the superconducting channel has a thickness of not more than five nanometers. Patent Application EP-A-0 354 804 further discloses that the superconducting thin film is epitaxially grown on the substrate but it doesn't well inform about the orientation of the epitaxially grown superconductor thin film. Patent Application EP-A-0 477 063 further discloses that it's a c-axis oriented superconducting thin film which is deposited on the substrate since the c-axis oriented thin film has a large critical current density in a direction in parallel to the substrate.

The Patent Application EP-A- 0 280 308 discloses a superconducting device, comprising a photoconductive substrate and a thin film of a superconductor constituting a weak link, source, drain and gate electrodes, this said superconducting device is made in order to operate as a photodetective device.

Both of the above mentioned superconducting-base -base transistor and the super-FET have a portion in which a semiconductor layer and a superconducting layer are stacked to each other. However, it is difficult to form a stacked structure of the semiconductor layer and the superconducting layer formed of an oxide superconductor which has been recently advanced in study. In addition, even if it is possible to form a stacked structure of the semiconductor layer and the oxide superconducting layer, it is difficult to control a boundary between the semiconductor layer and the oxide superconducting layer. Therefore, a satisfactory operation could not been obtained in these superconducting devices.

In addition, since the super-FET utilizes the superconducting proximity effect, the superconductor source electrode and the superconductor drain electrode have to be located close to each other at a distance which is a few times the coherence length of the superconductor materials of the superconductor source electrode and the superconductor drain electrode. In particular, since an oxide superconductor has a short coherence length, if the superconductor source electrode and the superconductor drain electrode are formed of the oxide superconductor material, a distance between the superconductor source electrode and the superconductor drain electrode has to be not greater than a few ten nanometers. However, it is very difficult to conduct a fine processing such as a fine pattern etching so as to ensure the very short separation distance. Because of this, in the prior art, it has been impossible to manufacture the super-FET composed of the oxide superconductor material.

Furthermore, it has been confirmed that the conventional three-terminal superconducting device having the superconducting channel shows a modulation operation. However, the conventional three-terminal superconducting device having the superconducting channel could not realize a complete ON/OFF operation, because a carrier density is too high. In this connection, since an oxide superconductor material has a low carrier density, it is expected to form a three-terminal superconducting device which has a superconducting channel and which can realize the complete ON/OFF operation, by forming the superconducting channel of the oxide superconductor material. In this case, however, a thickness of the superconducting channel has to be made on the order of five nanometers.

### Summary of the Invention

Accordingly, it is an object of the present invention to provide a superconducting device, which is formed of an oxide superconductor material and which has overcome the above mentioned defects of the conventional ones.

Another object of the present invention is to provide an FET type superconducting device including a superconducting channel constituted of an extremely thin oxide superconductor thin film, which can be manufactured by using existing established processing techniques with a good repeatability.

The above and other objects of the present invention are achieved in accordance with the present invention by a superconducting device comprising a substrate, a superconducting channel constituted of an oxide superconductor thin film formed on said substrate, a source electrode and a drain electrode formed at opposite ends of the superconducting channel so that a superconducting current can flow through the superconducting channel between the source electrode and the drain electrode , and a gate electrode located on the superconducting channel so as to control the superconducting current flowing through the superconducting channel, said gate electrode being formed on an insulating layer formed on the superconducting channel, characterized in that said superconducting channel , said source electrode and said drain electrode are formed of an oxide superconductor thin film having its a-axis oriented perpendicular to the substrate, said oxide superconductor thin film includes a thin portion which has a thickness of not greater than five nanometers in a direction of an electric field created by said gate electrode, and which constitutes said superconducting channel, and a pair of thick oxide superconductor thin film portions which are formed at opposite ends of said thin portion and on which said source electrode and said drain electrode are formed,respectively.

As seen from the above, the superconducting device in accordance with the present invention is characterized in that it comprises the superconducting channel constituted of the oxide superconductor thin film, the source electrode and the drain electrode for flowing the superconducting current through the superconducting channel, and the gate electrode for controlling the superconducting current flowing through the superconducting channel, and in that the gate electrode is located on an insulating layer formed on the superconducting channel, and the superconducting channel has a thickness of not greater than five nanometers in a direction of an electric field created by the gate electrode.

In the superconducting device in accordance with the present invention, the finest processing technique is to form the superconducting channel having the thickness of not greater than about five nanometers. In the structure of the superconducting device in accordance with the present invention, it is possible to form this extremely thin superconducting channel with neither a fine-etching nor a fine-patterning of the superconducting thin film. Therefore, it is possible to relax the limitation in the fine processing techniques such as a fine-etching or a fine-patterning which has been required in the case that conventional super-FET and the conventional superconducting-base transistor are formed using an oxide superconductor material. In addition, the stacked structure of the oxide superconducting layer and the semiconductor layer is no longer necessary.

In one embodiment of the superconducting device in accordance with the present invention, the superconducting channel is formed of a portion of an oxide superconductor thin film formed or deposited on a projection formed on a portion of a substrate surface. If this structure of the superconducting device is adopted, the superconducting channel can be easily formed by only depositing an oxide superconductor thin film having an appropriate thickness on a substrate having a projection formed on a portion of a substrate surface,

In another embodiment, the superconducting channel is formed of an oxide superconductor thin film having a thickness of not greater than five nanometers deposited on a planar surface of a substrate. In this case, it is sufficient if the oxide superconductor thin film having the thickness of not greater than five nanometers is deposited on the substrate

According to the present invention, there is provided a superconducting device comprising a substrate, a superconducting channel constituted of an oxide superconductor thin film formed on the substrate, a source electrode and a drain electrode formed at opposite ends of the superconducting channel so that a superconducting current can flow through the superconducting channel between the source electrode and the drain electrode, and a gate electrode located on the superconducting channel so as to control the superconducting current -flowing through the superconducting channel, the gate electrode being formed on an insulating layer formed on the superconducting channel, and the superconducting channel, the source electrode and the drain electrode being formed of an *a*-axis oriented oxide superconductor thin film.

Here, the source electrode should be understood to include not only an electrode corresponding to the electrode which is called a "source electrode" in the field of a semiconductor MOSFET, but also a source region which is formed adjacent to and continuous to the superconducting channel and on which the source electrode is formed, and the drain electrode should be understood to include not only an electrode corresponding to the electrode which is called a "drain electrode" in the field of the semiconductor MOSFET, but also a drain region which is formed adjacent to and continuous to the superconducting channel and on which the drain electrode is formed.

With the above mentioned arrangement, since the superconducting channel, the source electrode and the drain electrode are formed of an a -axis oriented oxide superconductor thin film, a flow of electrons become easy to flow through the source electrode, the superconducting channel and the drain electrode.

In a preferred embodiment, the oxide superconductor thin film is formed of a material selected from the group consisting of a Y-Ba-Cu-O type compound oxide superconductor material, a Bi-Sr-Ca-Cu-O type compound oxide superconductor material, and a Tl-Ba-Ca-Cu-O type compound oxide superconductor material.

In addition, the substrate, on which the oxide superconductor thin film is deposited, can be formed of an insulating substrate, preferably an oxide single crystalline substrate such as MgO, SrTiO₃, CdNdAlO₄, etc. These substrate materials are very effective in forming or growing a crystalline film having a high orientation property. However, the superconducting device can be formed on a semiconductor substrate if an appropriate buffer layer is deposited thereon. For example, the buffer layer on the semiconductor substrate can be formed of a double-layer coating formed of a MgAlO₄ layer and a BaTiO₃ layer if a silicon substrate is used.

The above and other objects, features and advantages of the present invention will be apparent from the following description of preferred embodiments of the invention with reference to the accompanying drawings.

### Brief Description of the Drawings

Figure 1 is a diagrammatic sectional view of a first embodiment of the superconducting device in accordance with the present invention;
Figure 2 is a diagrammatic sectional view of a second embodiment of the superconducting device in accordance with the present invention;
Figure 3 is a diagrammatic sectional view of a third embodiment of the superconducting device in accordance with the present invention; and.
Figure 4 is a diagrammatic sectional view of a fourth embodiment of the superconducting device in accordance with the present invention;

### Description of the Preferred embodiments

### Embodiment 1

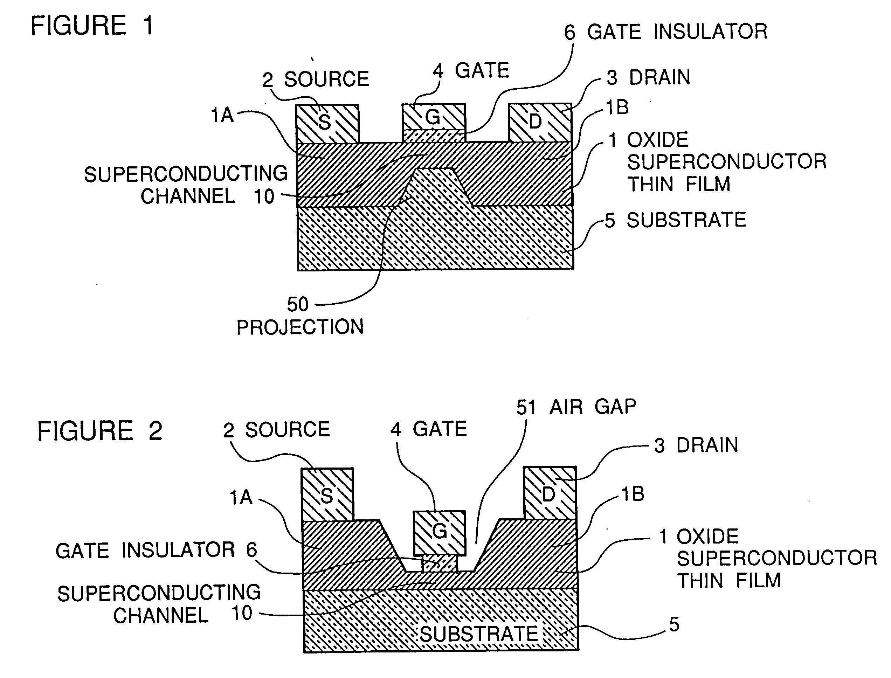

Referring to Figure 1, there is shown a diagrammatic sectional view of one embodiment of the superconducting device in accordance with the present invention. The shown superconducting device is a super-FET.

The super-FET includes an oxide superconducting layer 1 formed on a principal surface of a substrate 5 having a projection 50. The oxide superconducting layer 1 has a planarized upper surface, and therefore, a portion of the oxide superconducting layer 1 on the projection is thinner than the other portion of the oxide superconducting layer 1. This thin portion of the oxide superconducting layer 1 on the projection has a thickness of five nanometers and forms a superconducting channel 10. On the superconducting channel 10, a gate electrode 4 is formed through a gate insulator 6. In addition, a source electrode 2 and a drain electrode 3 are formed on the oxide superconducting layer 1 at both sides of the superconducting channel 10.

The projection 50 may be formed of a projection previously formed on a principal surface of the substrate 5, or can be formed of a non-superconducting portion of the oxide superconductor thin film 1 formed by diffusion of component of the substrate into the oxide superconductor thin thin 1. In the former case, the oxide superconducting thin film is deposited on the projection formed principal surface of the substrate 5, and therefore, it is in some case that the deposited oxide superconducting thin film has a projection corresponding to the projection previously formed on the substrate. In this case, the deposited oxide superconducting thin film can be etched backed and planarized so that a portion of the deposited oxide superconducting thin film above the projection of the substrate has a thickness of not greater than five nanometers.

On the other hand, if the projection 50 is formed of a non-superconducting portion of the oxide superconductor thin film 1 formed by diffusion of component of the substrate into the oxide superconductor thin film 1, a portion of the substrate covered with the oxide superconductor thin film 1 is selectively heated by for example a laser beam so that the component of the substrate is diffused from a heated portion into the oxide superconductor thin film 1. In this case, it is possible that elements easy to diffuse can be previously doped into a portion of the substrate corresponding to the position on which the projection is to be formed, so that when the oxide superconductor thin film is being deposited, the elements previously doped in the substrate are diffused into the oxide superconductor thin film.

### Embodiment 2

Referring to Figure 2, there is shown a second embodiment of the superconducting device. In Figure 2, elements or members corresponding to those shown in Figure 1 are given the same Reference Numerals. The second embodiment comprises a substrate 5 having a principal surface, and a superconducting channel 10 constituted of an oxide superconductor thin film which has a thickness of five nanometers and which is formed on the principal surface of the substrate 5. A gate electrode 4 is formed through a gate insulator 6 on the superconducting channel. A source electrode 2 and a drain electrode 3 are respectively formed on a pair of thick oxide superconductor thin film portions 1A and 1B which are formed at opposite ends of the superconducting channel 10. The pair of thick oxide superconductor thin film portions 1A and 1B can be formed by further depositing the thick oxide superconductor thin film using the gate electrode 4 as a mask, so that an air gap 51 is formed between the gate electrode 4 and the further deposited oxide superconductor thin film portions 1A and 1B.

### Embodiment 3

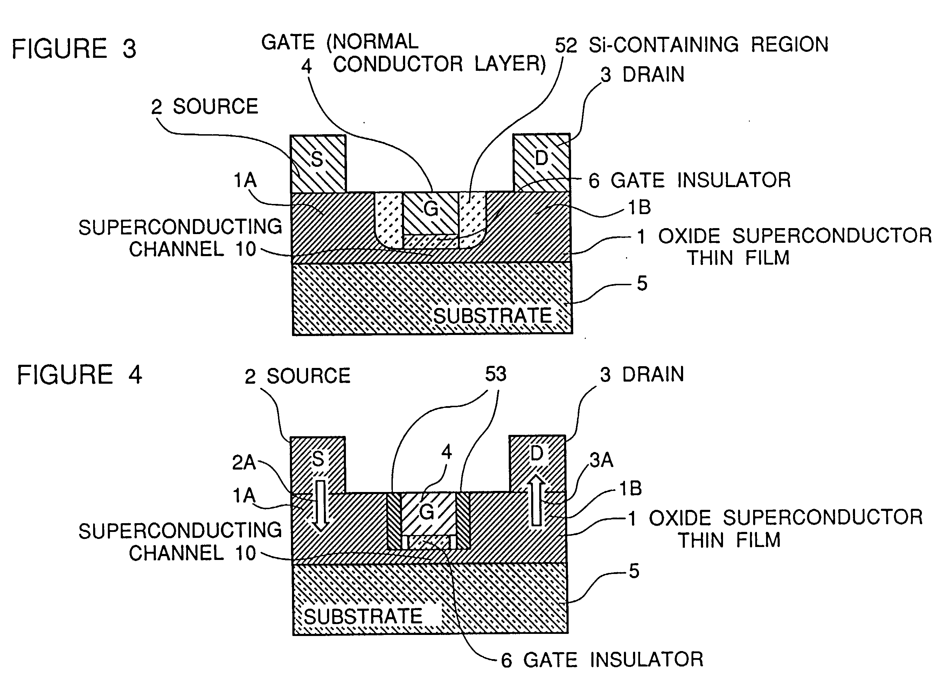

Referring to Figure 3, there is shown a third embodiment of the superconducting device. In Figure 3, elements or members corresponding to those shown in Figure 1 are given the same Reference Numerals. The third embodinent comprises a substrate 5 having a principal surface, and an oxide superconductor thin film 1 which is formed on the principal surface of the substrate 5 and which contains a gate electrode 4 embedded therein. A portion of the oxide superconductor thin film 1 under the gate electrode 4 has a thickness of five nanometers and forms a superconducting channel 10. The gate electrode 4 is formed of a normal conductor layer located on a gate insulator 6 formed directly on the superconducting channel 10. The normal conductor layer is formed of for example polysilicon or a compound containing silicon, such as silicide. In addition, a portion of the oxide superconducting layer 1 surrounding the gate electrode 4 is changed into a non-superconducting region 52 containing silicon diffused from the gate electrode 4 of the normal conductor layer.

This structure can be formed by depositing a first oxide superconductor thin film having the thickness of five nanometers on a principal surface of the substrate 5, forming on a portion of the first oxide superconductor thin film a stacked structure including a gate insulator 6 (also having a function of a diffusion preventing barrier) formed directly on the first oxide superconductor thin film and a gate electrode 4 of for example polysilicon formed on the gate insulator 6, and growing a second oxide superconductor thin film on an exposed surface of the first oxide superconductor thin film until the stacked structure is embedded in the second oxide superconductor thin film, so that silicon contained in the gate electrode 4 is diffused into an region 52 of the second oxide superconductor thin film surrounding the gate electrode 4, and the silicon diffused region 52 does not show superconductivity when a non-diffused region of the second oxide superconductor thin film shows superconductivity.

Therefore, the silicon diffused region 52 is formed of the oxide superconductor material doped with silicon. The silicon diffused region 52 has a critical temperature lower than the other portion of the oxide superconductor thin film 1, or does not any longer have superconductivity, because of the diffused impurity. Accordingly, when the super-FET is used at an operating temperature, the other portion of the oxide superconductor thin film 1 shows superconductivity, but the silicon diffused region 51 functions as an insulator, and therefore, the gate electrode 4 is electrically isolated from the oxide superconductor thin film by the gate insulator 6 and the silicon diffused region 51.

### Embodiment 4

A fourth embodiment of the superconducting device has the same structure as that of the first embodiment shown in Figure 1. Also in the fourth embodiment the oxide superconducting thin film 1 is formed of an *a*-axis oriented oxide superconductor crystal, so that the superconducting channel 10 is formed of the *a*-axis oriented oxide superconductor crystal and the pair of thick oxide superconducting thin film portions 1A and 1B continuous to opposite ends of the superconducting channel 10 are also formed of the *a*-axis oriented oxide superconductor crystal, and in that in some cases the source electrode 2 and the drain electrode 3 are superconducting electrodes formed of an *a*-axis oriented oxide superconductor crystal. This *a*-axis oriented oxide superconductor crystal can be formed by depositing an oxide superconductor thin film at a temperature lower than that for forming a *c*-axis oriented oxide superconductor crystal, for example, at a temperature of not greater than 650 °C in the case of Y-Ba-Cu-O type superconductor.

### Embodiment 5

A fifth embodiment of the superconducting device has the same structure as that of the second embodiment shown in Figure 2. Also in the fifth embodiment the oxide superconducting thin film 1 is formed of an *a*-axis oriented oxide superconductor crystal, so that the superconducting channel 10 is formed of the *a*-axis oriented oxide superconductor crystal and the pair of thick oxide superconducting thin film portions 1A and 1B continuous to opposite ends of the superconducting channel 10 are also formed of the *a*-axis oriented oxide superconductor crystal, and in that in some cases the source electrode 2 and the drain electrode 3 are superconducting electrodes formed of an *a*-axis oriented oxide superconductor crystal. This *a*-axis oriented oxide superconductor crystal can be formed similarly to the fourth embodiment.

### Embodiment 6

Referring to Figure 4, there is shown a sixth embodiment of the superconducting device. In Figure 4, elements or members corresponding to those shown in Figure 1 are given the same Reference Numerals. The sixth embodiment comprises a substrate 5 having a principal surface, and an oxide superconductor thin film 1 which is formed on the principal surface of the substrate 5 and which contains a gate electrode 4 embedded therein. A portion of the oxide superconductor thin film 1 under the gate electrode 4 has a thickness of five nanometers and forms a superconducting channel. The gate electrode 4 is formed of a metal and is located on a gate insulator 6 formed directly on the superconducting channel 10. A stacked structure of the gate electrode 4 and the gate insulator 6 has a side surface coated with an insulating layer 53. Therefore, the gate electrode 4 is isolated from oxide superconductor thin film 1 by the gate insulator 6 and the insulating layer 53.

This structure can be formed by (1) depositing a first oxide superconductor thin film having the thickness of five nanometers on a principal surface of the substrate 5, by an off-axis sputtering which is performed under the condition that a sputtering gas is composed of Ar and O₂ at the rate of Ar : O₂ = 9 : 1, the sputtering gas pressure is 10 Pa, and the temperature is 640°C, (2) forming on a portion of the first oxide superconductor thin film a stacked structure including a gate insulator 6 formed directly on the first oxide superconductor thin film and a metal gate electrode 4 of formed on the gate insulator, (3) covering a side surface of the stacked structure with an insulating member, (4) growing a second oxide superconductor thin film on an exposed surface of the first oxide superconductor thin film by the off-axis sputtering of the same condition as that for the first oxide superconductor thin film, until the stacked structure is embedded in the second oxide superconductor thin film, (5) depositing a third oxide superconductor thin film on the second oxide superconductor thin film separately from the gate electrode, by the off-axis sputtering of the same condition as that for the first oxide superconductor thin film, and (6) patterning the third oxide superconductor thin film so as to form the source electrode and the drain electrode.

As seen from the above, also in the sixth embodiment the oxide superconducting thin film 1 is formed of an *a*-axis oriented oxide superconductor crystal, so that the superconducting channel 10 is formed of the *a*-axis oriented oxide superconductor crystal and the pair of thick oxide superconducting thin film portions 1A and 1B continuous to opposite ends of the superconducting channel 10 are also formed of the *a*-axis oriented oxide superconductor crystal, and in that in some cases the source electrode 2 and the drain electrode 3 are superconducting electrodes formed of an *a*-axis oriented oxide superconductor crystal.

In the *a*-axis oriented oxide superconductor crystal formed on the substrate, a current density in a direction perpendicular to the substrate is larger than that in a direction parallel to the substrate. Therefore, a flow of electrons become easy to flow through the source electrode (including the source electrode 2 and the source region 1A) as shown by an arrow 2A in Figure 4, and also, a flow of electrons become easy to flow through the drain electrode (including the source electrode 3 and the source region 1B) as shown by an arrow 3A in Figure 4, so that the flow of electrons become easy to flow through the superconducting channel 10.

In the above mentioned Embodiment 6, the source electrode 2 and the drain electrode 3 may be formed of a normal conductor such a metal having a good electrical conductivity, since each of the source electrode 2 and the drain electrode 3 would have to be connected to a normal conductor in an actual situation.

### Embodiment 7

A seventh embodiment of the superconducting device has the same structure as that of the third embodiment shown in Figure 3. Also in the seventh embodiment the oxide superconducting thin film 1 is formed of an *a*-axis oriented oxide superconductor crystal, so that the superconducting channel 10 is formed of the *a*-axis oriented oxide superconductor crystal and the pair of thick oxide superconducting thin film portions 1A and 1B continuous to opposite ends of the superconducting channel 10 are also formed of the *a*-axis oriented oxide superconductor crystal, and in that in some cases the source electrode 2 and the drain electrode 3 are superconducting electrodes formed of an *a*-axis oriented oxide superconductor crystal. This *a*-axis oriented oxide superconductor crystal can be formed similarly to the fourth embodiment.

As seen from the above, the superconducting device in accordance with the present invention is characterized in that the superconducting current flowing through the superconducting channel is controlled by the voltage applied to the gate electrode. Accordingly, since it does not utilize a superconducting proximity effect which is used in the conventional super-FET, the superconducting device in accordance with the present invention can be formed with a relaxed limitation in the fine processing technique required for manufacturing the superconducting device. In addition, since the upper surface of the superconductor thin film can be planarized, it become easy to form conductor wirings in a later process. In addition, it is not necessary to stack the superconductor material and the semiconductor material to each other, a high performance device using the oxide superconduction device can be formed. Accordingly, it is easy to manufacture the superconducting device with good repeatability, and the manufactured superconducting device has a stable performance.

The invention has thus been shown and described with reference to the specific embodiments. However, it should be noted that the present invention is in no way limited to the details of the illustrated structures but changes and modifications may be made within the scope of the appended claims.

## Claims

1. A superconducting device comprising a substrate (5), a superconducting channel (10) constituted of an oxide superconductor thin film (1) formed on said substrate, a source electrode (2) and a drain electrode (3) formed at opposite ends of the superconducting channel so that a superconducting current can flow through the superconducting channel between the source electrode (2) and the drain electrode (3), and a gate electrode (4) located on the superconducting channel so as to control the superconducting current flowing through the superconducting channel, said gate electrode (4) being formed on an insulating layer (6) formed on the superconducting channel, characterized in that said superconducting channel (10), said source electrode (2) and said drain electrode (3) are formed of an oxide superconductor thin film having its a-axis oriented perpendicular to the substrate, said oxide superconductor thin film (1) includes a thin portion (10) which has a thickness of not greater than five nanometers in a direction of an electric field created by said gate electrode, and which constitutes said superconducting channel, and a pair of thick oxide superconductor thin film portions (1A and 1B) which are formed at opposite ends of said thin portion and on which said source electrode and said drain electrode are formed, respectively.

2. A superconducting device claimed in Claim 1 wherein said oxide superconductor thin film (1) is formed of an oxide superconductor material selected from the group consisting of a Y-Ba-Cu-O type compound oxide superconductor material, a Bi-Sr-Ca-Cu-O type compound oxide superconductor material, and a Tl-Ba-Cu-O type compound oxide superconductor material.

3. A superconducting device claimed in Claim 2 wherein the substrate (5) is formed of a material selected from the group consisting of a MgO (100) substrate, a SrTiO₃ (100) substrate and a CdNdAlO₄ (001) substrate, and a semiconductor substrate.

4. A superconducting device claimed in Claim 2 wherein the substrate (5) is formed of a silicon substrate and a principal surface of the silicon substrate is coated with an insulating material layer which is formed of a MgAlO₄ layer and a BaTiO₃ layer.

5. A superconducting device claimed in Claim 1 wherein said substrate (5) has a projection (50) formed in a principal surface thereof, and an oxide superconductor thin film (1) is formed to cover said projection (50) formed on said principal surface and has a substantially planar surface, said superconducting channel (10) being formed of a thinned portion of said oxide superconductor thin film (1) positioned on said projection (50).

6. A superconducting device claimed in Claim 5 wherein said projection (50) is formed of the same material as that of said substrate.

7. A superconducting device claimed in Claim 5 wherein said projection (50) is formed of a material which is the same as that of said oxide superconductor thin film (1) but which is diffused with constituents of said substrate or constituents added in said substrate (5).

8. A superconducting device claimed in Claim 1 wherein said substrate (5) has a planar principal surface, and said superconducting channel (10) is constituted of an oxide superconductor thin film (1) having a thickness of not greater than five nanometers formed on said principal surface of said substrate (5) and siad electrode (4) is formed on said insulating layer (6) which is formed on said oxide superconductor thin film (1) having a thickness of five nanometers, each of said source electrode and said drain electrode including a thick oxide superconductor portion which is formed on said superconductor thin film having a thickness of five nanometers and being located separately from a corresponding end of said gate electrode (4).

9. A superconducting device claimed in claim 1 wherein said substrate (5) has a planar principal surface, and an oxide superconductor thin film (1) is formed on said principal surface of said substrat so as to contain said gate electrode (4) embedded therein, a portion of said oxide superconductor thin film (1) under said gate electrode (4) having a thickness of not greater than five nanometers, and forming said superconducting channel (10), and said gate electrode (4) being isolated from said oxide superconductor thin film (1) by said insulating layer (6) and an insulator (53) formed on all sides surfaces of said gate electrode (4).

## Patentansprüche

1. Supraleitendes Bauelement mit einem Substrat 5, einem supraleitenden Kanal 10, bestehend aus einer oxydischen supraleitenden Dünnschicht 1, die auf dem Substrat ausgebildet ist, einer Source-Elektrode 2 und einer Drain-Elektrode 3, die an gegenüberliegenden Enden des supraleitenden Kanals derart ausgebildet sind, daß ein Supraleitungsstrom durch den supraleitenden Kanal zwischen der Source-Elektrode 2 und der Drain-Elektrode 3 fließen kann, und einer Gate-Elektrode 4, die auf dem supraleitenden Kanal derart angeordnet ist, daß sie den durch den supraleitenden Kanal fließenden Supraleitungsstrom steuert, wobei die Gate-Elektrode 4 auf einer Isolierschicht 6 angeordnet ist, welche auf dem supraleitenden Kanal ausgebildet ist, dadurch gekennzeichnet, daß der supraleitende Kanal 10, die Source-Elektrode 2 und die Drain-Elektrode 3 aus einer oxydischen supraleitenden Dünnschicht bestehen, deren a-Achse senkrecht zum Substrat ausgerichtet ist, daß die oxydische supraleitende Dünnschicht 1 einen dünnen Abschnitt 10 aufweist, dessen Dicke nicht größer als 5 nm in Richtung eines elektrischen Feldes ist, welches von der Gate-Elektrode erzeugt wird und der den supraleitenden Kanal darstellt und daß ein Paar dicker oxydischer supraleitender Dünnschichtabschnitte 1A und 1B an gegenüberliegenden Enden des dünnen Abschnitts ausgebildet sind, wobei auf ihnen die Source-Elektrode bzw. die Drain-Elektrode angeordnet sind.

2. Supraleitendes Bauteil nach Anspruch 1, bei dem die oxydische supraleitende Dünnschicht 1 aus einem oxydischen supraleitenden Material besteht, das ausgewählt ist aus der Gruppe supraleitender Materialien bestehend aus einem Y-Ba-Cu-O-Verbundoxyd, einem Bi-Sr-Ca-Cu-O-Verbundoxyd und einem Tl-Ba-Ca-Cu-O-Verbundoxyd.

3. Supraleitendes Bauteil nach Anspruch 2, bei dem das Substrat 5 aus einem Material besteht, das ausgewählt ist aus der Gruppe bestehend aus einem MgO-(100)-Substrat, einem SrTiO₃-(100)-Substrat, einem CdNdAlO₄-(001)-Substrat und einem Halbleiter-Substrat.

4. Supraleitendes Bauteil nach Anspruch 2, bei dem das Substrat 5 aus einem Siliziumsubstrat besteht, wobei eine Hauptoberfläche des Siliziumsubstrats mit einer Schicht aus einem isolierenden Material bedeckt ist, welche aus einer MgAlO₄-Schicht und einer BaTiO₃-Schicht besteht.

5. Supraleitendes Bauteil nach Anspruch 1, bei dem das Substrat 5 einen Vorsprung 50 auf einer seiner Hauptoberflächen aufweist, wobei eine oxydische supraleitende Dünnschicht 1 derart ausgebildet ist, daß sie diesen Vorsprung 50 auf der Hauptoberfläche bedeckt und eine im wesentlichen ebene Oberfläche aufweist, wobei der supraleitende Kanal 10 aus einem in seiner Dicke verringerten Abschnitt in der oxydischen supraleitenden Dünnschicht 1 oberhalb des Vorsprungs 50 besteht.

6. Supraleitendes Bauteil nach Anspruch 5, dadurch gekennzeichnet, daß der Vorsprung 50 aus dem gleichen Material besteht wie das Substrat.

7. Supraleitendes Bauteil nach Anspruch 5, bei dem der Vorsprung 50 aus dem gleichen Material wie die oxydische supraleitende Dünnschicht 1 besteht, in das jedoch Bestandteile des Substrates oder Bestandteile, die dem Substrat 5 hinzugefügt worden sind, eindiffundiert sind.

8. Supraleitendes Bauteil nach Anspruch 1, bei dem das Substrat 5 eine ebene Hauptoberfläche aufweist und bei dem der supraleitende Kanal 5 aus einer oxydischen supraleitenden Dünnschicht 1 besteht mit einer Dicke, die nicht größer als 5 nm ist und auf der Hauptoberfläche des Substrats 5 ausgebildet ist, und bei dem die Gate-Elektrode 4 auf der isolierenden Schicht 6 ausgebildet ist, welche auf der oxydischen supraleitenden Dünnschicht 1 mit der Dicke von 5 nm ausgebildet ist, wobei die Source-Elektrode und die Drain- Elektrode einen dicken oxydischen supraleitenden Abschnitt aufweisen, der auf der supraleitenden Dünnschicht mit einer Dicke von 5 nm ausgebildet ist und getrennt vom entsprechenden Ende der Gate-Elektrode 4 angeordnet ist.

9. Supraleitendes Bauteil nach Anspruch 1, bei dem das Substrat 5 eine ebene Hauptoberfläche aufweist, und eine oxydische supraleitende Dünnschicht 1 auf der Hauptoberfläche des Substrates derart angeordnet ist, daß sie eine darin eingebettete Gate-Elektrode 4 aufweist, wobei ein Abschnitt der oxydischen supraleitenden Dünnschicht 1 unterhalb der Gate-Elektrode 4 eine Dicke von nicht mehr als 5 nm aufweist und dabei den supraleitenden Kanal 10 darstellt, während die Gate-Elektrode 4 von der oxydischen supraleitenden Dünnschicht 1 durch die isolierende Schicht 6 isoliert ist, während ein Isolator 53 alle Seitenflächen der Gate-Elektrode 4 umgibt.

## Revendications

1. Dispositif à supraconducteur comprenant un substrat (5) , un canal supraconducteur (10) constitué d'un film mince de supraconducteur d'oxyde (1) formé sur ledit substrat , une électrode de source (2) et une électrode de drain (3) formées aux extrémités opposées du canal supraconducteur de sorte qu'un courant supraconducteur puisse circuler à travers le canal supraconducteur entre l'électrode de source (2) et l'électrode de drain (3),et une électrode de grille (4) est placée sur le canal supraconducteur de façon à commander le courant supraconducteur circulant à travers le canal supraconducteur , ladite électrode de grille (4) étant réalisée sur une couche isolante (6) formée sur le canal supraconducteur , caractérisé en ce que ledit canal supraconducteur (10) , ladite électrode de source (2) et ladite électrode de drain (3) sont formées d'un film mince de supraconducteur d'oxyde ayant son axe a orienté perpendiculairement au substrat, ledit film mince de supracondcuteur d'oxyde (1) comprend une partie mince (10) qui présente une épaisseur qui n'est pas supérieure à cinq manomètres dans la direction d'un champ électrique créé par ladite électrode de grille, et qui constitue ledit canal supraconducteur, et une paire de parties épaisses (1A et 1B) de film mince de supraconducteur d'oxyde qui sont formées au niveau des extrémités opposées de ladite partie mince et sur lesquelles ladite électrode de source et ladite électrode de drain sont formées respectivement.

2. Dispositif à supraconducteur selon la revendication 1 dans lequel ledit film mince de supraconducteur d'oxyde (1) est formé d'un matériau supraconducteur d'oxyde sélectionné dans le groupe constitué d'un matériau supraconducteur d'oxyde composé de type Y-Ba-Cu-O, d'un matériau supraconducteur d'oxyde composé de type Bi-Sr-Ca-Cu-O et d'un matériau supraconducteur d'oxyde composé de type Tl-Ba-Ca-Cu-O.

3. Dispositif à supraconducteur selon la revendication 2, dans lequel le substrat (5) est formé d'un matériau sélectionné dans le groupe constitué d'un substrat de MgO (100) , d'un substrat de SrTiO₃ (100) et d'un substrat de CdNdAlO₄ (001), et d'un substrat semiconducteur.

4. Dispositif à supraconducteur selon la revendication 2 dans lequel le substrat (5) est formé d'un substrat de silicium et une surface principale du substrat de silicium est recouverte d'une couche de matériau isolant qui est formée d'une couche de MgAlO₄ et d'une couche de BaTiO₃.

5. Dispositif à supraconducteur selon la revendication dans lequel ledit substrat (5) présente une partie en saillie (50) formée sur sa surface principale et un film mince de supraconducteur d'oxyde (1) est formé pour recouvrir ladite partie en saillie (50) formée sur ladite surface principale et présente une surface essentiellement plane , ledit canal supraconducteur (10) étant formé d'une partie amincie dudit film mince de supraconducteur d'oxyde (1) positionnée sur ladite saillie (50).

6. Dispositif à supraconducteur selon la revendication 5 dans lequel ladite saillie (50) est constituée du même matériau que celui dudit substrat.

7. Dispositif à supraconducteur selon la revendication 5 dans lequel ladite saillie (50) est constituée d'un matériau qui est le même que celui dudit film mince de supraconducteur d'oxyde (1) mais dans lequel diffusent des constituants dudit substrat ou des constituants ajoutés dans ledit substrat (5).

8. Dispositif à supraconducteur selon la revendication dans lequel ledit substrat (5) présente une surface principale plane et ledit canal supraconducteur (10) est constitué d'un film mince de supraconducteur d'oxyde (1) présentant une épaisseur qui n'est pas supérieure à cinq manomètres formé sur ladite surface principale dudit substrat (5) et ladite électrode de grille (4) est réalisée sur ladite couche isolante (6) qui est formée sur ledit film mince de supraconducteur d'oxyde (1) présentant une épaisseur de cinq manomètres , chacune de ladite électrode de source et de ladite électrode de drain incluant une partie épaisse de supraconducteur d'oxyde qui est formée sur ledit film mince supraconducteur présentant une épaisseur de cinq manomètres et étant placée à distance d'une extrémité correspondante de ladite électrode de grille (4).

9. Dispositif à supraconducteur selon la revendication 1, dans lequel ledit substrat (5) présente une surface principale plane et un film mince de supraconducteur d'oxyde (1) est formé sur ladite surface principale dudit substrat de façon à contenir ladite électrode de grille (4) noyée à l'intérieur , une partie dudit film mince de supraconducteur d'oxyde (1) située sous ladite électrode de grille (4) présentant une épaisseur qui n'est pas supérieure à cinq manomètres , et formant ledit canal supraconducteur (10), et ladite électrode de grille (4) étant isolée dudit film mince de supraconducteur d'oxyde (1) par ladite couche isolante (6) et un isolateur (53) formé sur toutes les surfaces latérales de ladite électrode de grille (4).
